# EUROPÄISCHE PATENTANMELDUNG

(11) **EP 4 661 070 A1**
(43) Veröffentlichungstag der Anmeldung: **10.12.2025**
(21) Anmeldenummer: 24180460.8
(22) Anmeldetag: 06.06.2024
(51) Int. Cl.: H01L 23/00

(54) **VERFAHREN ZUM VERBINDEN VON ELEKTRONISCHEN BAUELEMENTEN**

(71) Anmelder: Heraeus Electronics GmbH & Co. KG, 63450 Hanau (DE)
(72) Erfinder: Stegmann, Tamira, 63450 Hanau (DE); Gunst, Stefan, 63450 Hanau (DE); Schwöbel, Andre, 63450 Hanau (DE); Durst, Karsten, 64287 Darmstadt (DE); Bruder, Enrico, 64287 Darmstadt (DE)
(74) Vertreter: Heraeus IP

(57) **Zusammenfassung**

Verfahren zum Verbinden von elektronischen Bauelementen, bei dem man (1) eine Sandwichanordnung bereitstellt, die zwei jeweils Metallkontaktflächen aufweisende elektronische Bauelemente A und B und eine zwischen einer Metallkontaktfläche A' des elektronischen Bauelementes A und einer Metallkontaktfläche B` des elektronischen Bauelementes B befindliche Metallsinterzusammensetzung aufweist, (2) optional, die Metallsinterzusammensetzung trocknet und (3) die Sandwichanordnung sintert, wobei die Metallsinterzusammensetzung, bezogen auf ihren nichtflüchtigen Anteil, 80 bis 100 Gew.-% Metallpartikel (i) mit einer Teilchengröße D90 im Bereich von 1 bis 20 µm umfasst, wobei die Metallkontaktfläche A' einen arithmetischen Mittenrauwert RaA und die Metallkontaktfläche B' einen arithmetischen Mittenrauwert RaB aufweist, und wobei mindestens einer der Quotienten RaA/D90 und RaB/D90 im Bereich von 0,05 bis 0,3 liegt.

## Beschreibung

Die Erfindung betrifft ein Verfahren zum Verbinden von elektronischen Bauelementen.

Der hierin verwendete Begriff "elektronisches Bauelement" bezeichnet Bauteile, die in der Elektronik verwendet werden und die jeweils mindestens eine metallisierte Kontaktfläche oder eine Kontaktfläche aus Metall aufweisen; bei dem Metall oder der Metallisierung kann es sich beispielsweise um jeweils legiertes oder unlegiertes Kupfer, Silber, Gold, Palladium, Aluminium oder Nickel handeln. Beispiele für solche elektronischen Bauelemente umfassen Dioden, LEDs (light emitting diodes, lichtemittierende Dioden), Dies, IGBTs (insulated-gate bipolar transistors, Bipolartransistoren mit isolierter Gate-Elektrode), MOSFETs (Metall-Oxid-Halbleiter-Feldeffekttransistoren), ICs (integrated circuits, integrierte Schaltungen), Sensoren, Kühlkörper, Widerstände, Kondensatoren, Spulen, Verbindungselemente (z. B. Clips), Bodenplatten, Antennen, Leadframes, PCBs (printed circuit boards, gedruckte Leiterplatten), flexible Elektronik, Metallkeramiksubstrate wie beispielsweise DCB-Substrate (direct copper bonded-Substrate), IMS (isoliertes Metallsubstrat) und dergleichen.

Im Bereich der Leistungs- und Konsumerelektronik stellt das Sinterverbinden elektronischer Bauelemente ein gängiges Verfahren dar. Als Verbindungsmaterial wird dabei häufig Metallsinterpaste verwendet, deren Hauptbestandteile dispergierte sinterfähige Metallpartikel sind. Prominente Beispiele für solche Metallsinterpasten umfassen dem Fachmann bekannte Silbersinterpasten. Die Sinterverbindungstechnik stellt ein sehr einfaches Verfahren zum stabilen Verbinden von Bauelementen dar, wobei die zu verbindenden Bauelemente mit ihren zu verbindenden Kontaktflächen zueinander gewandt in eine Sandwichanordnung überführt werden mit dazwischen appliziertem Sinterverbindungsmaterial, beispielsweise Metallsinterpaste. Die unter Verwendung von Metallsinterpaste geschaffene Sandwichanordnung wird anschließend einem Trocknungs- und Sinterschritt unterworfen, in dessen Verlauf die mechanisch feste, elektrisch und wärmeleitfähige Verbindung zwischen den Bauelementen ausgebildet wird. Das mechanisch feste Verbinden zweier Bauelemente ist also ein Befestigen des einen Bauelements an bzw. auf dem zweiten Bauelement über deren jeweilige Kontaktflächen.

Aufgabe der Erfindung war es, ein Verfahren zum Verbinden von elektronischen Bauelementen zu finden, welches die Herstellung besagter Sandwichanordnungen mit besonders hoher Verbindungsfestigkeit erlaubt.

Die Lösung der Aufgabe wurde in einer Feinabstimmung zwischen Rauheit, genauer gesagt dem arithmetischem Mittenrauwert Ra, einer der oder beider zu verbindenden Metallkontaktflächen von elektronischen Bauelementen einerseits und der Verwendung einer Metallsinterzusammensetzung mit Metallpartikeln mit einer bestimmten Teilchengröße D90 andererseits gefunden; dabei hat sich herausgestellt, dass die Einhaltung eines bestimmten Quotienten Ra/D90 erfindungswesentlich ist. Demgemäß betrifft die Erfindung ein Verfahren zum Verbinden von elektronischen Bauelementen, bei dem man (1) eine Sandwichanordnung bereitstellt, die zwei jeweils Metallkontaktflächen aufweisende elektronische Bauelemente A und B und eine zwischen einer Metallkontaktfläche A' des elektronischen Bauelementes A und einer Metallkontaktfläche B' des elektronischen Bauelementes B befindliche Metallsinterzusammensetzung aufweist, (2) optional, die Metallsinterzusammensetzung trocknet und (3) die Sandwichanordnung sintert,
wobei die Metallsinterzusammensetzung, bezogen auf ihren nichtflüchtigen Anteil, 80 bis 100 Gew.-% (Gewichts-%) Metallpartikel (i) mit einer Teilchengröße D90 im Bereich von 1 bis 20 µm umfasst,
wobei die Metallkontaktfläche A' einen arithmetischen Mittenrauwert RaA und die Metallkontaktfläche B' einen arithmetischen Mittenrauwert RaB aufweist, und wobei mindestens einer der Quotienten RaA/D90 und RaB/D90 im Bereich von 0,05 bis 0,3 liegt.

Der hierin verwendete Ausdruck "nichtflüchtiger Anteil" bedeutet den von flüchtigen Substanzen freien Anteil, wobei "flüchtige Substanzen" Substanzen mit einem Siede- oder Zersetzungspunkt ≤ 280°C bedeutet; Beispiele umfassen dabei insbesondere derartige organische Lösemittel. Es kann sein, dass die Metallsinterzusammensetzung frei von definitionsgemäßen flüchtigen Substanzen ist.

Bei der Metallsinterzusammensetzung kann es sich um eine feste Zusammensetzung handeln, beispielsweise eine Metallsintervorform. Eine Metallsintervorform ist ein folienartiges beispielsweise 5 bis 300 µm dünnes Stück nicht gesinterter Metallsinterzusammensetzung, beispielsweise getrockneter und nicht gesinterter Metallsinterzusammensetzung; sie kann beispielsweise durch Auftragen von nichtfester Metallsinterzusammensetzung auf einen flachen Träger, Trocknen ohne Sinterung und anschließendes Abziehen hergestellt werden. Eine derartige feste Metallsinterzusammensetzung zeichnet sich durch einen geringen Anteil flüchtiger Substanzen aus.

Bevorzugt handelt es sich bei der Metallsinterzusammensetzung um eine nichtfeste Zusammensetzung von mehr oder weniger ausgeprägt flüssiger, insbesondere pastöser Konsistenz. Bevorzugte Beispiele umfassen sogenannte Metallsinterpasten. In einer bevorzugten Ausführungsform betrifft die Erfindung daher ein Verfahren zum Verbinden von elektronischen Bauelementen, bei dem man (1) eine Sandwichanordnung bereitstellt, die zwei jeweils Metallkontaktflächen aufweisende elektronische Bauelemente A und B und eine zwischen einer Metallkontaktfläche A' des elektronischen Bauelementes A und einer Metallkontaktfläche B' des elektronischen Bauelementes B befindliche nichtfeste Metallsinterzusammensetzung aufweist, (2) optional, jedoch bevorzugt die nichtfeste Metallsinterzusammensetzung trocknet und (3) die Sandwichanordnung sintert,
wobei die nichtfeste Metallsinterzusammensetzung besteht aus:
   (i) 50 bis 90 Gew.-%, bevorzugt 60 bis 85 Gew.-%, insbesondere 70 bis 85 Gew.-% Metallpartikeln mit einer Teilchengröße D90 im Bereich von 1 bis 20 µm,
   (ii) 10 bis 50 Gew.-%, bevorzugt 15 bis 40 Gew.-%, insbesondere 15 bis 30 Gew.-% mindestens eines organischen Lösemittels, und
   (iii) 0 bis 20 Gew.-%, bevorzugt 0 bis 10 Gew.-%, insbesondere 0 bis 5 Gew.-%, speziell 0,1 bis 5 Gew.-% oder sogar nur 0,2 bis 3 Gew.-% mindestens eines von den Bestandteilen (i) und (ii) verschiedenen Bestandteils, und
wobei die Metallkontaktfläche A' einen arithmetischen Mittenrauwert RaA und die Metallkontaktfläche B' einen arithmetischen Mittenrauwert RaB aufweist, und
wobei mindestens einer der Quotienten RaA/D90 und RaB/D90 im Bereich von 0,05 bis 0,3 liegt.

Unter Trocknen wird das Entfernen von flüchtigen Substanzen, insbesondere von organischem Lösemittel aus der applizierten und insbesondere nichtfesten Metallsinterzusammensetzung verstanden. Die Schritte (1), (2) und (3) bilden eine Schrittfolge vom Typ (1)-(2)-(3) mit Schritt (2) als optionalem Schritt. In einer Ausführungsform des erfindungsgemäßen Verfahrens kann Schritt (1) schon ein Trocknen umfassen und Schritt (2) kann somit entfallen; in einer anderen Ausführungsform umfasst Schritt (1) das Trocknen nicht oder nur teilweise und der optionale Schritt (2) kann entfallen oder bevorzugt stattfinden; falls Schritt (2) hier entfällt, kann er im Zuge von Schritt (3) stattfinden bzw. damit überlappen. Es kann auch sein, dass kein Trocknen notwendig ist und daher entfällt.

Die elektronischen Bauelemente A und B umfassen jeweils - soweit sie nicht ohnehin aus Metall bestehen - wenigstens eine Metallkontaktfläche A' respektive B' einer der eingangs schon erwähnten Typen. Über die Metallkontaktflächen A' und B' erfolgt die besagte Sandwichanordnung im Rahmen des erfindungsgemäßen Verfahrens.

Bevorzugt weist die Metallkontaktfläche A' einen arithmetischen Mittenrauwert RaA im Bereich von 0,1 bis 2,5 µm auf; besonders bevorzugt ist dabei der Bereich von 0,5 bis 2,0 µm, insbesondere der Bereich von 0,75 bis 1,5 µm. Gleiches gilt für den arithmetischen Mittenrauwert RaB der Metallkontaktfläche B', welcher auch bevorzugt im Bereich von 0,1 bis 2,5 µm, besonders bevorzugt im Bereich von 0,5 bis 2,0 µm und insbesondere im Bereich von 0,75 bis 1,5 µm liegt.

Eine erfindungswesentliche Bedingung ist wie schon gesagt, dass mindestens einer der Quotienten RaA/D90 und RaB/D90 im Bereich von 0,05 bis 0,3 liegt.

Ra steht für den arithmetischen Mittenrauwert gemäß der zum Anmeldetag gültigen Version der DIN EN ISO 4287. Beispielsweise kann zur Bestimmung des Mittenrauwerts Ra das Konfokalmikroskop µsurf custom (NanoFocus AG, Deutschland) verwendet werden. Hierzu werden an der Metallkontaktfläche A' und/oder B' 3D-Aufnahmen der Oberfläche angefertigt. Mittels der Software µSoft Analysis Premium (7.4.8872; NanoFocus AG, Deutschland) können die mikroskopischen 3D-Aufnahmen ausgewertet werden. Hierzu ist zunächst eine eventuelle Durchbiegung der Metallkontaktflächen A' und/oder B' in den 3D-Aufnahmen zu korrigieren. Danach kann der Mittenrauwert Ra aus dem Rauheitsprofil der Oberfläche unter Verwendung eines Gauß-Filters erhalten werden.

Ein arithmetischer Mittenrauwert RaA respektive RaB im gewünschten und bevorzugten Bereich von 0,1 bis 2,5 µm kann mittels geeigneter Techniken eingestellt werden. Beispiele für dazu geeignete Techniken umfassen abrasives Schleifen, Strahlen, Polieren, chemisches Ätzen und Laserstrukturierung.

Abrasives Schleifen (nass oder trocken) kann beispielsweise mittels rotierender oder in eine Längs- bzw. Querrichtung verfahrbarer Schleifscheiben oder Schleifbänder in manuell betriebenen oder automatisierten Anlagen erfolgen. Beispiele für Schleifmaterialien umfassen Diamant und kubisches Bornitrid. Die Körnungen der Schleifmaterialien können beispielsweise im Bereich von 30 µm bis 150 µm liegen und des gewünschten Materialabtrags entsprechend gewählt werden.

Beim Strahlen kann die betreffende Metallkontaktfläche durch das Beschießen mit Partikeln wie Sand oder Glasperlen bearbeitet werden. Geeignete Durchmesser der Strahlmittelpartikel liegen beispielsweise bei 40 bis 70 µm. Das Strahlmittel wird dabei mit hoher Geschwindigkeit auf die zu bearbeitende Oberfläche geschleudert, bevorzugt mit einer Druckluftstrahlanlage mit einem Druck beispielsweise im Bereich von 2 bis 10 bar.

Polieren führt zu einer Oberflächenglättung, d.h. zu einer Verkleinerung arithmetischer Mittenrauwerte. Hierbei können zweckmäßig Poliermittel mit kleinen Korndurchmessern beispielsweise <20 µm verwendet werden.

Beim chemischen Ätzen mit z.B. Eisen(III)-chlorid kann ebenfalls Material abgetragen und damit ein gewünschter arithmetischer Mittenrauwert Ra erzeugt werden, ohne die betreffende Metallkontaktoberfläche mechanisch zu verformen. Dazu wird die Oberfläche für mehrere Minuten bis Tage in die Ätzlösung gehalten, welche dann chemisch an der Oberfläche angreift, und Material abträgt.

In Schritt (1) des erfindungsgemäßen Verfahrens werden zunächst die elektronischen Bauelemente A und B miteinander in Kontakt gebracht. Das Kontaktieren erfolgt dabei über die Metallsinterzusammensetzung, letztere wie gesagt gegebenenfalls schon getrocknet. Zu diesem Zweck wird eine Sandwichanordnung bereitgestellt, bei der sich zwischen den elektronischen Bauelementen A und B Metallsinterzusammensetzung befindet. Unter Sandwichanordnung ist hier eine Anordnung zu verstehen, bei der sich zwei elektronische Bauelemente A und B übereinander befinden und im Wesentlichen parallel zueinander angeordnet sind.

Die Sandwichanordnung kann nach einem aus dem Stand der Technik bekannten Verfahren hergestellt werden. Dabei wird die betreffende Metallkontaktfläche A' oder B' eines der elektronischen Bauelemente A oder B mit der Metallsinterzusammensetzung versehen. Anschließend wird das andere Bauelement B oder A mit seiner Metallkontaktfläche B' oder A' auf die Metallsinterzusammensetzung, die auf die Metallkontaktfläche A' oder B' des einen elektronischen Bauelements A oder B aufgebracht worden ist, aufgesetzt.

Die Auftragung der Metallsinterzusammensetzung auf die betreffende Metallkontaktfläche A' oder B' des einen elektronischen Bauelements A oder B kann mittels herkömmlicher Verfahren erfolgen, im Falle einer nichtfesten Metallsinterzusammensetzung beispielsweise mittels Druckverfahren wie Siebdruck oder Schablonendruck. Andererseits kann die Auftragung auch mittels Dispenstechnik, Jetten, mittels Pintransfer oder durch Dippen erfolgen. Im Falle einer festen Metallsinterzusammensetzung kann die Aufbringung durch Auflegen auf bzw. Bestücken der festen Metallsinterzusammensetzung auf die betreffende Metallkontaktfläche A' oder B' erfolgen.

Die Nassschichtdicke von nichtfester Metallsinterzusammensetzung liegt vorzugsweise im Bereich von 20 bis 400 µm. Die bevorzugte Nassschichtdicke ist beispielsweise abhängig vom gewählten Auftragungsverfahren. Wird die nichtfeste Metallsinterzusammensetzung beispielsweise mittels Siebdruckverfahren aufgetragen, dann kann eine Nassschichtdicke von beispielsweise 20 bis 60 µm bevorzugt sein. Erfolgt die Auftragung beispielsweise mittels Schablonendruck, dann kann die bevorzugte Nassschichtdicke beispielsweise im Bereich von 20 bis 400 µm liegen. Beispielsweise bei der Dispenstechnik kann die bevorzugte Nassschichtdicke beispielsweise im Bereich von 20 bis 400 µm liegen je nach verwendetem Auftragungswerkzeug, beispielsweise bei Verwendung einer Hohlnadel im Bereich von 20 bis 100 µm oder beispielsweise bei Verwendung einer zugleich als Rakel fungierenden Breitschlitzdüse im Bereich von 50 bis 400 µm.

Im Anschluss an die Aufbringung der Metallsinterzusammensetzung auf die Metallkontaktfläche A' oder B' des einen elektronischen Bauelements A oder B wird die mit der gegebenenfalls teilweise oder vollständig getrockneten Metallsinterzusammensetzung versehene Metallkontaktfläche A' oder B' dieses elektronischen Bauelements A oder B mit der entsprechenden Metallkontaktfläche B' oder A' des damit zu verbindenden elektronischen Bauelements B oder A über die Metallsinterzusammensetzung in Kontakt gebracht. Somit befindet sich zwischen den zu verbindenden elektronischen Bauelementen A und B eine Schicht nicht, teilweise oder vollständig getrocknete Metallsinterzusammensetzung im Sinne der Bildung der Sandwichanordnung.

Gemäß einer bevorzugten Ausführungsform liegt der Anteil an organischem Lösemittel in der Metallsinterzusammensetzung nach einer Trocknung beispielsweise bei 0 bis 5 Gew.-%, bezogen auf einen ursprünglichen Anteil an organischem Lösemittel in der Metallsinterzusammensetzung. Mit anderen Worten, bei der Trocknung gemäß dieser bevorzugten Ausführungsform werden beispielsweise 95 bis 100 Gew.-% des oder der ursprünglich in einer Metallsinterzusammensetzung enthaltenen organischen Lösemittel entfernt.

Die Trocknungstemperatur in einem stattfindenden Schritt (2) liegt vorzugsweise im Bereich von 100 bis 150 °C. Übliche Trocknungszeiten liegen beispielsweise im Bereich von 5 bis 45 Minuten. Zur Verkürzung der Trocknungszeit kann unterstützend ein Vakuum verwendet werden, beispielsweise ein Druck im Bereich von 100 bis 300 mbar.

Nach Beendigung von Schritt (1) respektive Schritt (2) wird die Sandwichanordnung schließlich einem Sinterprozess unterworfen.

Hierin wird unter Sintern das Verbinden von zwei elektronischen Bauelementen A und B durch Erhitzen unter Vermeidung dessen, dass die Metallpartikel der Metallsinterzusammensetzung die flüssige Phase erreichen, verstanden. Die dabei gebildete feste mechanische Verbindung ist zugleich elektrisch und thermisch leitfähig; sie, d.h. der zwischen den Bauelementen A und B gebildete Metallsinterkörper, besteht wesentlich bis hin zu vollständig aus dem Metall der Metallpartikel (i).

Dieser Sinterschritt (3) des erfindungsgemäßen Verfahrens wird bevorzugt unter Druckanwendung durchgeführt. Beim Drucksintern liegt der Prozessdruck vorzugsweise unter 30 MPa und mehr bevorzugt unter 15 MPa. Beispielsweise liegt der Prozessdruck im Bereich von 1 bis 30 MPa und mehr bevorzugt im Bereich von 5 bis 15 MPa.

Das eigentliche Sintern erfolgt bei einer Temperatur von beispielsweise 200 bis 280 °C.

Die Sinterzeit liegt beispielsweise im Bereich von 2 bis 60 Minuten, bevorzugt 2 bis 10 Minuten.

Der Sinterprozess kann in einer Atmosphäre erfolgen, die keinen besonderen Beschränkungen unterliegt. So kann das Sintern einerseits in einer Atmosphäre durchgeführt werden, die Sauerstoff enthält. Andererseits ist es auch möglich, das Sintern in sauerstofffreier Atmosphäre oder im Vakuum durchzuführen. Unter sauerstofffreier Atmosphäre ist im Rahmen der Erfindung eine Atmosphäre zu verstehen, deren Sauerstoffgehalt nicht mehr als 300 Gew.-ppm (Gewichts-ppm), vorzugsweise nicht mehr als 100 Gew.-ppm und noch mehr bevorzugt nicht mehr als 50 Gew.-ppm beträgt.

Das Sintern wird in einer herkömmlichen, zum Sintern, insbesondere Drucksintern geeigneten Vorrichtung durchgeführt, in der sich die vorstehend beschriebenen Prozessparameter einstellen lassen.

Eine ebenfalls erfindungswesentliche Bedingung ist, dass die von der im erfindungsgemäßen Verfahren verwendeten Metallsinterzusammensetzung umfassten Metallpartikel (i) eine Teilchengröße D90 im Bereich von 1 bis 20 µm, bevorzugt im Bereich von > 1 bis 20 µm aufweisen; insbesondere liegt die Teilchengröße D90 im Bereich von 2 bis 15 µm oder ganz besonders im Bereich von 3 bis 10 µm. Dabei liegt die Teilchengröße D10 bevorzugt im Bereich von 0,2 bis 2 µm, besonders bevorzugt im Bereich von 0,5 bis 2 µm und insbesondere im Bereich von 0,7 bis 1,5 µm.

Der hierin im Zusammenhang mit den Metallpartikeln (i) verwendete Begriff "Teilchengröße D90" bedeutet den mittels Laserbeugung bestimmbaren Primärteilchendurchmesser, der von einem Volumenanteil von 90 % der Teilchen unterschritten wird und der hierin im Zusammenhang mit den Metallpartikeln (i) verwendete Begriff "Teilchengröße D10" bedeutet den mittels Laserbeugung bestimmbaren Primärteilchendurchmesser, der von einem Volumenanteil von 10 % der Teilchen unterschritten wird. Laserbeugungsmessungen können mit einem entsprechenden Teilchengrößenmessgerät, beispielsweise einem Mastersizer 3000 oder einem Mastersizer 2000 von Malvern Instruments nach der Nassbestimmungsmethode durchgeführt werden. Bei der Nassbestimmungsmethode können im Rahmen der Probenvorbereitung beispielsweise 1 g Metallpartikel vom Typ (i) in 200 ml Ethanol mittels Ultraschall dispergiert werden.

Bei dem Metall der Metallpartikel (i) kann es sich beispielsweise um Kupfer oder insbesondere um Silber handeln. Auch ummantelte Metallpartikel sind möglich, beispielsweise solche, bei denen insbesondere ein Mantel aus Silber oder Kupfer einen Kern aus einem anderen Metall umschließt. Bei dem Metall des Kerns kann es sich um ein unedleres Metall, beispielsweise Nickel oder Kupfer handeln.

Die Metallpartikel (i) können Metallflakes (Metallplättchen), sphärische Metallpartikel oder eine Mischung aus Metallflakes und sphärischen Metallpartikeln sein, bevorzugt sind Metallflakes alleine. Das Aspektverhältnis der Metallflakes kann beispielsweise bei > 5 : 1 liegen, beispielsweise bei > 5 : 1 bis mehrere Hundert: 1. Das Aspektverhältnis von sphärischen Metallpartikeln liegt bei 5 : 1 bis 1 : 1, insbesondere bei 3 : 1 bis 1 : 1. Das Aspektverhältnis von Teilchen beschreibt den Quotienten aus größter und kleinster Längenausdehnung derselben und damit deren Form; bei Metallflakes ist der Quotient aus größter und kleinster Längenausdehnung der Quotient aus größter Längenausdehnung und der Plättchendicke. Es kann durch Rasterelektronenmikroskopie und Auswertung der elektronenmikroskopischen Bilder durch Bestimmung der Abmessungen einer statistisch bedeutsamen Anzahl von einzelnen Teilchen bestimmt werden.

Die Metallflakes können eine spezifische Oberfläche beispielsweise im Bereich von 1 bis 5 m²/g aufweisen. Die sphärischen Metallpartikel können eine spezifische Oberfläche beispielsweise im Bereich von 1 bis 8 m²/g aufweisen. Die spezifische Oberfläche in m²/g kann mittels BET-Messung gemäß DIN ISO 9277:2014-01 (statisch-volumetrisches Messverfahren, verwendetes Gas: Stickstoff) bestimmt werden.

Die Metallflakes können eine Stampfdichte beispielsweise im Bereich von 1 bis 5 g/cm3 aufweisen. Die sphärischen Metallpartikel können eine Stampfdichte beispielsweise im Bereich von 3 bis 6 g/cm³ aufweisen. Bei der Stampfdichte handelt es sich um die durch Stampfen oder Rütteln gegenüber der Schüttdichte eines Feststoffs weiter verdichtete Dichte. Die Stampfdichte in g/cm³ kann gemäß DIN EN ISO 787-11:1995-10 bestimmt werden.

Die Metallpartikel (i) sind üblicherweise gecoatet (beschichtet). Die hierin gemachten Gewichtsangaben schließen das Gewicht des Coatings (Beschichtung) auf den Metallpartikeln (i) mit ein.

Das vorerwähnte Coating kann eine festhaftende Schicht auf der Oberfläche der Metallpartikel (i) sein. Üblicherweise handelt es sich um ein organisches Coating. Der Anteil des organischen Coatings kann beispielsweise im Bereich von 0,5 bis 2,0 Gew.-%, bezogen auf Metall, liegen. Im Allgemeinen kann ein solches organisches Coating 90 bis 100 Gew.-% einer oder mehrerer Fettsäuren und/oder Fettsäurederivate oder Amine umfassen. Beispiele für Fettsäurederivate umfassen insbesondere Fettsäuresalze, Fettsäureamide und Fettsäureester. Beispiele für Fettsäuren umfassen Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Ölsäure (9-Octadecensäure), Arachinsäure (Eicosansäure/Icosansäure), Behensäure (Docosansäure), Lignocerinsäure (Tetracosansäure).

Metallpartikel vom Typ (i) sind kommerziell erhältlich. Besagte Metallflakes sind beispielsweise bei den Firmen Metalor oder Ames Goldsmith kommerziell erhältlich. Besagte sphärische Metallpartikel sind beispielsweise von Ames Goldsmith kommerziell erhältlich.

Es kann sich bei Bestandteil (i) der Metallsinterzusammensetzung um eine einzige Metallpartikeltype vom Typ (i) oder um eine Kombination zweier oder mehrerer Metallpartikeltypen vom Typ (i) handeln; entscheidend ist, dass sich Bestandteil (i) der Metallsinterzusammensetzung durch eine Teilchengröße D90 im Bereich von 1 bis 20 µm auszeichnet und dabei bevorzugt nur eine Art von Metall umfasst, speziell Silber.

Beim von der Metallsinterzusammensetzung gegebenenfalls, von der nichtfesten Metallsinterzusammensetzung jedenfalls umfassten Bestandteil (ii) handelt es sich um mindestens ein organisches Lösemittel. Beispiele für geeignete organische Lösemittel umfassen Terpineole, N-Methyl-2-pyrrolidon, Ethylenglykol, Dimethylacetamid, 1-Tridecanol, 2-Tridecanol, 3-Tridecanol, 4-Tridecanol, 5-Tridecanol, 6-Tridecanol, Isotridecanol, 2-Ethyl-1,3-hexandiol, 2-(2-Ethylhexyloxy)-ethanol, Benzylalkohol, Diethylenglykolmonobutylether, Dipropylenglykolmonopropylether, Dipropylenglykolmonobutylether, dibasische Ester (vorzugsweise Dimethylester der Glutar-, Adipin- oder Bernsteinsäure oder Mischungen davon), Glycerin, Diethylenglykol, Triethylenglykol und aliphatische, insbesondere gesättigte aliphatische Kohlenwasserstoffe mit 5 bis 32 C-Atomen, mehr bevorzugt 10 bis 25 C-Atomen und noch mehr bevorzugt 16 bis 20 C-Atomen.

Beim optionalen, bevorzugt jedoch von der Metallsinterzusammensetzung umfassten Bestandteil (iii) handelt es sich um mindestens einen von Metallpartikeln (i) und organischem Lösemittel (ii) verschiedenen Bestandteil. Beispiele umfassen andere Metallpartikel als solche vom Typ (i), thermisch zersetzbare Metallprecursoren (Metallvorläuferverbindungen), Additive wie beispielsweise Tenside, Entschäumer, und Benetzungsmittel, Polymere, beispielsweise Cellulosederivate wie beispielsweise Methylcellulose, Ethylcellulose, Ethylmethylcellulose, Carboxycellulose, Hydroxypropylcellulose, Hydroxyethylcellulose und Hydroxymethylcellulose.

Bezogen auf die Metallsinterzusammensetzung beträgt die Summe der Gew.-% der Bestandteile (i) bis (iii) 100 Gew.-%. Dementsprechend kann die Herstellung der nichtfesten Metallsinterzusammensetzung durch Vermischen der Bestandteile (i) und (ii) respektive (i) bis (iii) erfolgen. Dabei können übliche dem Fachmann bekannte Vorrichtungen verwendet werden, beispielsweise Rührwerke, Dreiwalzwerke, Leitstrahlmischer und/oder Dispermixer.

Mittels des erfindungsgemäßen Verfahrens kann eine gesinterte Sandwichanordnung erhalten werden, welche sich durch hohe Verbindungsfestigkeit, geringe Porosität des die elektronischen Bauelemente A und B der gesinterten Sandwichanordnung verbindenden Metallsinterkörpers auszeichnet. Die geringe Porosität kann insbesondere niedrig ausgeprägt sein im Bereich der direkten Nachbarschaft zwischen Metallsinterkörper und Metallkontaktfläche(n) A' und/oder B'. Es wird angenommen, dass hierin ein, wenn nicht sogar der Schlüssel für die als Scherfestigkeit messtechnisch erfassbare hohe Verbindungsfestigkeit liegt.

### Beispiele

### Erfindungsgemäße Beispiele 1 bis 4 und Vergleichsbeispiele 5 und 6, allgemeine Durchführung:

### 1. Bereitstellung von Kupfer-Keramik-Substraten (27 mm x 38 mm)

In den erfindungsgemäßen Beispielen 1, 2 und 4 wurden Kupfer-Keramik-Substrate mit hinsichtlich des arithmetischen Mittenrauwertes Ra modifizierten Kupferkontaktfläche verwendet. Die entsprechende Modifizierung erfolgte durch chemisches Ätzen mittels wässriger Eisen(III)chlorid-Lösung (vgl. Tabelle 2).

Im erfindungsgemäßen Beispiel 3 wurde die Kupferkontaktfläche mittels Schleifen hinsichtlich des arithmetischen Mittenrauwertes Ra modifiziert. Dazu wurde das Kupfer-Keramik-Substrat in einer automatisierten Anlage durch Vakuumansaugung fixiert und dessen Oberfläche bei Zugabe eines Kühlschmiermittels mit einer rotierenden Diamant-Schleifscheibe mit 126 µm Korndurchmesser in Längsrichtung bearbeitet.

In den Vergleichsbeispielen V5 und V6 wurde anstelle des Schleifens Strahlen mit Glasperlen mit einem Durchmesser im Bereich von 40 µm bis 70 µm bei 4 bar Luftdruck durchgeführt.

### 2. Herstellung von Silbersinterpasten

Zunächst wurden organische Lösemittel sowie Ethylcellulose bei 80 °C zu einem Lösemittelsystem homogenisiert. Anschließend wurden portionsweise Silberpartikel dem Lösemittelsystem zugegeben und vollständig dispergiert. Die verwendeten Rohstoffe sind Tabelle 1 (Angaben in Gewichts-%) zu entnehmen.

**Tabelle 1: Zusammensetzung der Silbersinterpasten.**

| | Silberpartikel | Ethylcellulose | Terpineol | Tridecanol |
|---|---|---|---|---|
| 1 | 82* | 0,36 | 8,82 | 8,82 |
| 2 | 82* | 0,36 | 8,82 | 8,82 |
| 3 | 82* | 0,36 | 8,82 | 8,82 |
| 4 | 85** | 0,3 | 7,35 | 7,35 |
| V1 | 82* | 0,36 | 8,82 | 8,82 |
| V2 | 85** | 0,3 | 7,35 | 7,35 |
| * mit Fettsäure gecoatete Partikel mit D90 = 6.3 µm (siehe Tabelle 2) | | | | |
| ** mit Fettsäure gecoatete Partikel mit D90 = 3.0 µm (siehe Tabelle 2) | | | | |

### 3. Herstellung von Sandwichanordnungen

Die jeweilige Silbersinterpaste (vgl. Tabelle 1) wurde mittels Schablonendruck in einer Nassschichtdicke von 150 µm auf die Kupferoberfläche der Kupfer-Keramik-Substrate aufgebracht (vgl. Tabelle 2). Im Anschluss erfolgte ein Trockenschritt bei 140 °C für 20 min in Stickstoffatmosphäre in einem Konvektionsofen. Anschließend wurde die getrocknete Silbersinterpaste mit einem unterseitig mit Silber metallisierten Silizium-Chip (4 mm x 4 mm) unter Verwendung eines halbautomatisierten Chip-Bestückers der Firma Tresky bestückt. Dazu wurde der Chip für 2000 ms bei einer Kraft von 2000 g bei 80 °C in die getrocknete Paste gedrückt. Die so geschaffene Sandwichanordnung wurde in Stickstoffatmosphäre (<100 ppm Sauerstoff) unter Druckbeaufschlagung von 10 MPa in einer Heißpresse bei 230 °C für 3 Minuten gesintert.

### 4. Evaluierung der Verbindungsfestigkeit

Zur Bestimmung der Verbindungsfestigkeit wurde die Scherfestigkeit der Sandwichanordnung ermittelt. Dazu wurde das Testequipment Nordson Dage 4000Plus verwendet. Ein Schermeißel setzt hier in Höhe von 30 µm, gemessen ab Höhe der gesinterten Sinterpaste, am Chip, d.h. dem oberen Bauelement der Sandwichanordnung an und schert den Chip mit einer Geschwindigkeit von 300 µm/s bei Raumtemperatur (21 °C) ab. Die Kraft bis zum Versagen der Verbindung wurde mit einer 20 kN Kraftmessdose aufgenommen.

**Tabelle 2: Aufbau und Bewertung der erfindungsgemäßen Beispiele 1 bis 4 sowie der Vergleichsbeispiele V1 bis V2.**

| | Ra [µm] | D90 [µm] | Ra/D90 | Scherfestigkeit [MPa] | Bewertung |
|---|---|---|---|---|---|
| 1 | 0,370 | 6,3 | 0,059 | 40,7 | + |
| 2 | 0,720 | 6,3 | 0,114 | 44,3 | + |
| 3 | 1,470 | 6,3 | 0,233 | 39,5 | + |
| 4 | 0,370 | 3,0 | 0,123 | 41,2 | + |
| V5 | 2,430 | 6,3 | 0,386 | 30,7 | - |
| V6 | 2,430 | 3,0 | 0,810 | 21,5 | - |

## Patentansprüche

1. Verfahren zum Verbinden von elektronischen Bauelementen, bei dem man (1) eine Sandwichanordnung bereitstellt, die zwei jeweils Metallkontaktflächen aufweisende elektronische Bauelemente A und B und eine zwischen einer Metallkontaktfläche A' des elektronischen Bauelementes A und einer Metallkontaktfläche B' des elektronischen Bauelementes B befindliche Metallsinterzusammensetzung aufweist, (2) optional, die Metallsinterzusammensetzung trocknet und (3) die Sandwichanordnung sintert,
wobei die Metallsinterzusammensetzung, bezogen auf ihren nichtflüchtigen Anteil, 80 bis 100 Gew.-% Metallpartikel (i) mit einer Teilchengröße D90 im Bereich von 1 bis 20 µm umfasst, wobei die Metallkontaktfläche A' einen arithmetischen Mittenrauwert RaA und die Metallkontaktfläche B' einen arithmetischen Mittenrauwert RaB aufweist, und
wobei mindestens einer der Quotienten RaA/D90 und RaB/D90 im Bereich von 0,05 bis 0,3 liegt.

2. Verfahren nach Anspruch 1, wobei es sich bei der Metallsinterzusammensetzung um eine feste Zusammensetzung oder um eine nichtfeste Zusammensetzung handelt.

3. Verfahren zum Verbinden von elektronischen Bauelementen, bei dem man (1) eine Sandwichanordnung bereitstellt, die zwei jeweils Metallkontaktflächen aufweisende elektronische Bauelemente A und B und eine zwischen einer Metallkontaktfläche A' des elektronischen Bauelementes A und einer Metallkontaktfläche B' des elektronischen Bauelementes B befindliche nichtfeste Metallsinterzusammensetzung aufweist, (2) optional, jedoch bevorzugt die nichtfeste Metallsinterzusammensetzung trocknet und (3) die Sandwichanordnung sintert,
wobei die nichtfeste Metallsinterzusammensetzung besteht aus:
(i) 50 bis 90 Gew.-%, bevorzugt 60 bis 85 Gew.-%, insbesondere 70 bis 85 Gew.-% Metallpartikeln mit einer Teilchengröße D90 im Bereich von 1 bis 20 µm,
(ii) 10 bis 50 Gew.-%, bevorzugt 15 bis 40 Gew.-%, insbesondere 15 bis 30 Gew.-% mindestens eines organischen Lösemittels, und
(iii) 0 bis 20 Gew.-%, bevorzugt 0 bis 10 Gew.-%, insbesondere 0 bis 5 Gew.-%, speziell 0,1 bis 5 Gew.-% oder sogar nur 0,2 bis 3 Gew.-% mindestens eines von den Bestandteilen (i) und (ii) verschiedenen Bestandteils, und
wobei die Metallkontaktfläche A' einen arithmetischen Mittenrauwert RaA und die Metallkontaktfläche B' einen arithmetischen Mittenrauwert RaB aufweist, und
wobei mindestens einer der Quotienten RaA/D90 und RaB/D90 im Bereich von 0,05 bis 0,3 liegt.

4. Verfahren nach einem der vorhergehenden Ansprüche, wobei der arithmetische Mittenrauwert RaA im Bereich von 0,1 bis 2,5 µm, bevorzugt im Bereich von 0,5 bis 2,0 µm, und insbesondere im Bereich von 0,75 bis 1,5 µm liegt.

5. Verfahren nach einem der vorhergehenden Ansprüche, wobei der arithmetische Mittenrauwert RaB im Bereich von 0,1 bis 2,5 µm, bevorzugt im Bereich von 0,5 bis 2,0 µm, und insbesondere im Bereich von 0,75 bis 1,5 µm liegt.

6. Verfahren nach einem der vorhergehenden Ansprüche, wobei es sich bei dem Metall der Metallpartikel (i) um Kupfer oder um Silber handelt.

7. Verfahren nach einem der Ansprüche 1 bis 5, wobei die Metallpartikel (i) ummantelte Metallpartikel umfassen.

8. Verfahren nach einem der vorhergehenden Ansprüche, wobei die Metallpartikel (i) Metallflakes und/oder sphärische Metallpartikel sind.

9. Verfahren nach einem der vorhergehenden Ansprüche, wobei die Metallpartikel (i) gecoatet sind.

10. Nach einem Verfahren eines der vorhergehenden Ansprüche erhältliche gesinterte Sandwichanordnung.
